Europäisches Patentamt

European Patent Office

Office européen des brevets

(19)

(11) Veröffentlichungsnummer : **0 172 273**
**B1**

(12)

# EUROPÄISCHE PATENTSCHRIFT

(45) Veröffentlichungstag der Patentschrift :
04.05.88

(21) Anmeldenummer : 84116367.8

(22) Anmeldetag : 27.12.84

(51) Int. Cl.⁴ : **G 01 P   3/489**, G 01 R 15/08

(54) Verfahren und Einrichtung zur digitalen Drehzahlmessung.

(30) Priorität : 06.07.84 DE 3424898

(43) Veröffentlichungstag der Anmeldung :
26.02.86 Patentblatt 86/09

(45) Bekanntmachung des Hinweises auf die Patenterteilung : 04.05.88 Patentblatt 88/18

(84) Benannte Vertragsstaaten :
DE FR GB NL SE

(56) Entgegenhaltungen :
DE-A- 2 635 004
FR-A- 2 154 373

(73) Patentinhaber : VDO Adolf Schindling AG
Gräfstrasse 103
D-6000 Frankfurt/Main (DE)

(72) Erfinder : Collonia, Harald, Dipl. -Ing.
Weizenacker 13
D 6251 Beselich/Schupach (DE)

(74) Vertreter : Klein, Thomas, Dipl.-Ing. (FH)
Sodener Strasse 9 Postfach 6140
D-6231 Schwalbach a. Ts. (DE)

EP 0 172 273 B1

Jouve, 18, rue St-Denis, 75001 Paris, France

## Beschreibung

Die Erfindung betrifft ein Verfahren zur digitalen Drehzahlmessung nach dem Oberbegriff des Anspruchs 1.

Ein weiterer Aspekt der Erfindung betrifft eine Einrichtung zur Durchführung dieses Verfahrens nach dem Oberbegriff des Anspruchs 3.

Insbesondere zur Regelung der Leerlaufdrehzahl von Verbrennungsmotoren wird ein Signal benötigt, welches in einem wenigstens annähernd linearen Zusammenhang zu der Motordrehzahl steht.

Hierzu wird nach dem Stand der Technik ausgegangen von der Zündfrequenz als Maß der Motordrehzahl. Nach dem bekannten Prinzip der Periodendauermessung ist ein mehrstufiger Zähler vorgesehen, in den über ein Tor eine feste Zählfrequenz eingespeist wird, wobei das Tor während der Periodendauer der Zündfrequenz geöffnet wird. In den Zähler wird so für jede Periode ein Zählwert eingezählt, der zur Periodendauer und Zählfrequenz proportional ist. Die Abhängigkeit der Zählerstände von der Drehzahl ist jedoch nicht linear, nämlich in einer graphischen Darstellung hyperbelförmig. Die Steigung der hyperbelförmigen Kurve ist stark von der Drehzahl abhängig. Wegen dieser Nicht-Linearität können die Zählwerte nicht unmittelbar für Regelungszwecke verwendet werden.

Es ist nach dem Stand der Technik denkbar, die der Periodendauer proportionalen Zählwerte durch Reziprokwertbildung mit einem Rechenwerk umzurechnen. Damit kann eine lineare Abhängigkeit der umgerechneten Zählwerte von der Drehzahl erzielt werden. Der Aufwand für einen Rechner mit einem solchen Zählwerk ist aber verhältnismäßig hoch, um so mehr als der Rechner verhältnismäßig schnell arbeiten muß, um möglichst zeitgleich und mit hoher Auflösung die Motordrehzahlwerte zu errechnen.

Der vorliegenden Erfindung liegt daher die Aufgabe zugrunde, den Kennlinienverlauf von drehzahlabhängigen Zählwerten bei hoher Auflösung und hoher Arbeitsgeschwindigkeit mit geringem schaltungstechnischen Aufwand annähernd zu linearisieren.

Diese Aufgabe wird für ein Verfahren der eingangs genannten Gattung dadurch gelöst, daß die Zählfrequenz bei Erreichen vorgegebener Zählwerte während der jeweils ausgezählten Periodendauer herabgesetzt wird, wenn die Zählwerte vorbestimmte Werte überschreiten.

Die Periodendauer wird hier also nicht immer mit konstanter Zählfrequenz ausgezählt, sondern nur dann und solange der jeweilige Zählwert einen vorgegebenen Wert nicht überschreitet. Beim Überschreiten des vorgegebenen Zählwerts erfolgt der weitere Zählvorgang mit einer herabgesetzten Zählfrequenz. Somit kann ohne großen Aufwand, d. h. ohne Rechenkapazität für eine Reziprokwertbildung und mit hoher Auflösung eine annähernde Linearisierung des Kennlinienverlaufs der am Ende jeder Periodendauer erreichen Zählwerte in Abhängigkeit von der Motordrehzahl erreicht werden.

Es hat sich herausgestellt, daß sich gemäß Anspruch 2 zwei Umschaltpunkte zum Einspeisen einer von drei möglichen Zählfrequenzen in den Zähler genügen, um den Kennlinienverlauf für Drehzahlregelungen von Verbrennungsmotoren im Leerlaufbereich bis ca. 1 500 U/min ausreichend zu linearisieren.

Ein grundsätzlicher weiterer Vorteil des erfindungsgemäßen Verfahrens besteht darin, daß die niedrigste Meßfrequenz bzw. Drehzahl bei gleichem Aufwand bzw. Anzahl Zählerstufen gegenüber einer nichtlinearisierten Messung herabgesetzt werden kann, beispielsweise von 240 U/min auf 160 U/min bei einem bestimmten Verbrennungsmotortyp.

Eine besonders wenig aufwendige Einrichtung zur Ausübung des erfindungsgemäßen Verfahrens ist in dem kennzeichnenden Teil des Anspruchs 3 angegeben. Diese Einrichtung kann zweckmäßig mit einem Digital-IC realisiert werden.

Der schaltungstechnische Aufwand insbesondere für die Logik-Schaltanordnung wird weiter herabgesetzt, indem gemäß Anspruch 4 nur die Ausgänge der beiden höchsten Zählerstufen in der Logik-Schaltanordnung miteinander zu verknüpfen sind. Damit kann in drei Kennlinienabschnitten je eine von drei vorgegebenen Zählfrequenzen in den Zähler eingezählt werden. Für die Erfassung der Zündfrequenz bzw. der Drehzahl genügt dabei ein Zähler mit einer verhältnismäßig geringen Anzahl Zählerstufen.

Die Erfindung wird im folgenden anhand einer Zeichnung mit zwei Figuren erläutert. Es zeigen:

Fig. 1 eine vereinfachte Schaltungsanordnung der Einrichtung zur digitalen Drehzahlmessung, und

Fig. 2 eine nichtlinearisierte Zählwertkennlinie und eine mit der Einrichtung nach Fig. 1 linearisierte Zählwertkennlinie in Abhängigkeit von der Motordrehzahl.

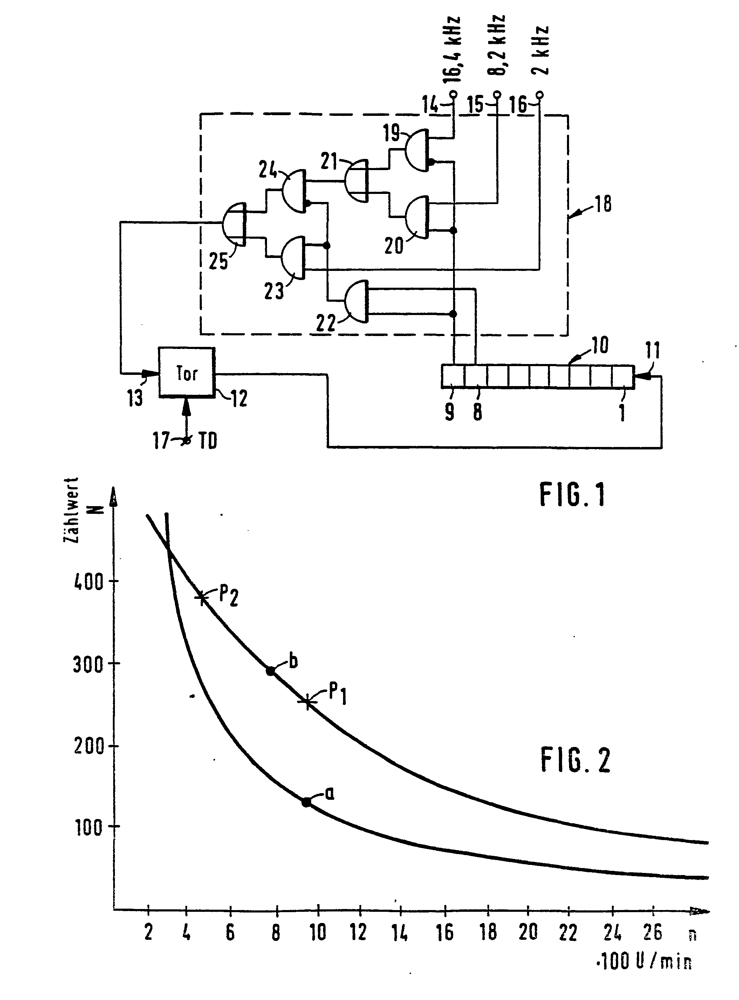

In Fig. 1 ist mit 10 ein Zähler mit neun Zählerstufen bezeichnet, von denen nur die niedrigste mit 1 und die beiden höchsten Stufen 8 und 9 gekennzeichnet sind. In einen Eingang 11 des Zählers ist über ein Tor 12 eine Zählfrequenz einspeisbar, die an einem Eingang 13 des Tors ansteht. Als Zählfrequenz stehen drei Frequenzen auf je einer Leitung 14 bzw. 15 bzw. 16 zur Verfügung. Die Zählfrequenzen werden mit nichtdargestellten Mitteln, beispielsweise durch Unterteilung einer höchsten Zählfrequenz, gebildet. Konkret stehen die Zählfrequenzen 16,4 kHz auf der Leitung 14, 8,2 kHz auf der Leitung 15 und 2 kHz auf der Leitung 16 zur Verfügung.

Das Tor ist durch eine Zündfrequenz steuerbar, die an einer Klemme 17 (TD) ansteht.

Zur Durchschaltung einer der drei Zählfrequenzen von den Leitungen 14, 15, 16 auf den Eingang 13 des Tors steht eine Logik-Schaltanordnung zur Verfügung, die innerhalb der unterbrochenen Linien dargestellt und allgemein mit 18 bezeichnet ist. Sie ist mit sieben Logikelementen 19 bis 25 so aufgebaut, daß je eine der Leitungen 14, 15, 16 zu dem Eingang 13 des Tors in Abhängigkeit von dem Inhalt der höchstwertigen Zählerstufen 8 und 9 durchschaltbar ist. Im einzelnen ergibt sich die Verknüpfung der Logik-Schaltanordnung aus der nachstehend beschriebenen Wirkungsweise.

In Fig. 2 ist mit der nichtlinearisierten Kennlinie a dargestellt, wie die Zählwerte N von der Drehzahl n hyperbelförmig abhängen, wenn für alle Drehzahlen eine konstante Zählfrequenz in den Zähler 10 über das Tor 12 in Abhängigkeit von einer der Drehzahl entsprechenden Periodendauer — Signal an der Klemme 17 — eingespeist wird. Es ist für diesen Fall also speziell angenommen, daß die Zählfrequenz unabhängig von der Drehzahl bzw. Periodendauer zu dem Eingang 13 des Tors durchgeschaltet ist. Aus der Darstellung ist der stark gekrümmte Verlauf insbesondere in dem Bereich niedriger Drehzahlen bis 1 500 U/min erkennbar.

Mit der Schaltungsanordnung nach Fig. 1 wird der Zählerstand des Zählers 10 nur dann mit der höchsten Frequenz, d. h. 16,4 kHz auf der Leitung 14 hochgezählt, solange noch keine binäre Stelle des Zählwertes in die Zählerstufe 9 eingezählt wird. Das heißt, daß nur bei hohen Zündfrequenzen bis zu dem Zählwert 255 mit der Frequenz 16,4 kHz, genau 16,384 kHz, gezählt wird. In diesem Fall ist das UND-Glied 19 mit einem invertierten Eingang zu der Zählerstufe 9 durchgeschaltet und führt über ein ODER-Glied 21 zu einem Eingang des UND-Glieds 24 mit einem invertierenden Eingang. Das UND-Glied 24 schaltet die höchste Zählfrequenz weiter durch, da an seinem invertierenden Eingang ein Null-Signal liegt. Das Null-Signal entsteht dadurch, daß keinem der Eingänge des UND-Glieds 22 ein Signal anliegt, welches einen Inhalt der Zählerstufen 8 und 9 bedeutet. Hingegen wird unter dieser Bedingung — kein Zählwert in den Zählerstufen 8 und 9 — die Zählfrequenz von 8,2 kHz, genau 8,192 kHz, nicht durchgeschaltet. Hierfür sorgt das UND-Glied 20. Auch die noch niedrigere Zählfrequenz von 2 kHz, genau 2,048 kHz, wird nicht zu dem Tor weitergeleitet, da das UND-Glied 23 gesperrt ist.

Erst wenn der Zählwert in dem Zähler 10 den Betrag von 255 überschreitet, wird anstelle der höchsten Zählfrequenz 16,4 kHz die nächst niedrigere Zählfrequenz von 8,2 kHz zu dem Tor 12 weitergeleitet : Dies erfolgt über das UND-Glied 20, das jetzt ein Signal von der höchsten Zählerstufe 9 erhält, welches die Füllung dieser Stufe signalisiert. Das Signal wird über das ODER-Glied 21 und das UND-Glied 24 sowie das ODER-Glied 25 zu dem Tor 12 weitergeleitet, da von dem Ausgang des UND-Glieds 22 nach wie vor ein Null-Signal abgegeben wird, denn der Inhalt der Zählerstufe 8 ist wieder Null. Aus diesem Grund wird auch die niedrigstmögliche Zählfrequenz auf der Leitung 16 nicht über das UND-Glied 23 weitergeleitet. Die Weiterleitung der höchsten Zählfrequenz 16,4 kHz auf der Leitung 14 wird durch das UND-Glied 19 unterbrochen, da an dessen invertierendem Eingang das Signal anliegt, welches die Füllung der höchsten Zählerstufe 9 bedeutet.

Letzterer Zustand des UND-Glieds 19 wird auch beigehalten, wenn bei noch niedrigeren Motordrehzahlen auch die Zählerstufe 8 wieder gefüllt wird, während die Füllung der höchsten Zählerstufe 9 beibehalten bleibt. Dies bedeutet, daß eine weitere Umschaltung bei dem Zählwert 384 erfolgt. Die Weiterleitung der mittleren Zählfrequenz 8,2 kHz wird durch das UND-Glied 24 unterbrochen, da an dessen invertierendem Eingang ein Signal ansteht, welches gebildet durch das UND-Glied 22 die Füllung der Zählerstufen 8 und 9 bedeutet. Es wird lediglich die niedrigste Zählfrequenz 2 kHz über das UND-Glied 23 und das ODER-Glied 25 zu dem Tor 12 geleitet, bis der Zählwert 511 erreicht ist.

Insgesamt hat also die Logik-Schaltanordnung 18 die Funktion eines EXCLUSIV-ODER.

Aus der Darstellung der Kennlinie b, die in der voranstehend beschriebenen Weise erreicht wird, ist ohne weiteres ersichtlich, wie bei Drehzahlen unterhalb von Umschaltpunkten $T_1$ bzw. $P_2$ eine linearisierende Abflachung der Kennlinie erfolgt.

## Patentansprüche

1. Verfahren zur digitalen Drehzahlmessung durch Messung der Periodendauer, die mit einer Zählfrequenz ausgezählt wird, dadurch gekennzeichnet , daß die Zählfrequenz bei Erreichen und Überschreiten vorgegebener Zählwerte während der jeweils ausgezählten Periodendauer so herabgesetzt wird, daß dadurch die bis zum Ende der Periodendauer erreichten Zählwerte mit der Drehzahl in annähernd linearem Zusammenhang Stehen.

2. Verfahren nach Anspruch 1, dadurch gekennzeichnet, daß die Zählfrequenz zum ersten Mal herabgesetzt wird, wenn ein erster vorbestimmter Zählwert während einer Periodendauer erreicht wird, und daß die Zählfrequenz zum zweiten Mal reduziert wird, wenn ein zweiter vorbestimmter Zählwert während der Periodendauer erreicht wird.

3. Einrichtung zur digitalen Drehzahlmessung mit einem Zähler (10), mit einem durch die Periodendauer eines Drehzahlsignals gesteuerten Tor (12), durch das eine Zählfrequenz in den Zähler (10) einspeisbar ist, dadurch gekennzeichnet, daß eine Logik-Schaltanordnung (18) vorgesehen ist, über die je eine von mehreren vorgegebenen Zählfrequenzen über das Tor (12) in den Zähler (10) einspeisbar ist, und daß die Logik-Schaltanordnung mit Ausgängen von Zählerstufen (8, 9) des Zählers zur Durchschaltung je einer dem Zählerstand zugeordneten Zählfrequenz in Verbindung steht.

4. Einrichtung mit einem mehrstufigen Zähler nach Anspruch 3, dadurch gekennzeichnet, daß nur die beiden höchsten Zählerstufen (8, 9) mit der Logik-Schaltanordnung (18) in Verbindung stehen.

## Claims

1. Method for the digital measurement of rotational speed by measuring the period, which is counted with a counting frequency, characterised in that the counting frequency is reduced in such a manner on attainment of and exceeding predetermined count values during the respective period being counted that as a result the count values achieved up to the end of the period are in approximately linear interrelationship with the rotational speed.

2. Method according to claim 1, characterised in that the counting frequency is reduced for the first time when a first predetermined count value is reached during a period, and that the counting frequency is reduced for the second time when a second predetermined count value is reached during the period.

3. Apparatus for the digital measurement of rotational speed, with a counter (10), with a gate (12) which is controlled by the period of a rotational speed signal and whereby a counting frequency can be fed into the counter (10), characterised in that a logic circuit arrangement (18) is provided by means of which one in each case of a plurality of predetermined counting frequencies can be fed into the counter (10) through the gate (12), and that the logic circuit arrangement is connected to outputs of stages (8, 9) of the counter for switching-through in each case a counting frequency associated with the count.

4. Apparatus with a multi-stage counter according to claim 3, characterised in that only the two highest counter stages (8, 9) are connected to the logic circuit arrangement (18).

## Revendications

1. Procédé pour la mesure numérique de la vitesse de rotation grâce à la mesure de la durée des périodes, qui est décomptée au moyen d'une fréquence de comptage, procédé caractérisé en ce que la fréquence de comptage est abaissée lorsque des valeurs de comptage fixées à l'avance sont atteintes et dépassées pendant la durée de période en cours de décomptage, de sorte que les valeurs de comptage atteintes à la fin de la durée de période sont en relation approximativement linéaire avec la vitesse de rotation.

2. Procédé selon la revendication 1, caractérisé en ce que la fréquence de comptage est abaissée pour la première fois quand une première valeur de comptage, fixée à l'avance, est atteinte au cours d'une durée de période et en ce que la fréquence de comptage, est abaissée pour la deuxième fois lorsqu'une deuxième valeur de comptage, fixée à l'avance, est atteinte au cours de la durée de période.

3. Dispositif pour la mesure numérique de la vitesse de rotation comportant un compteur (10) muni d'une porte (12) commandée par la durée de période d'un signal de vitesse de rotation et grâce à laquelle porte une fréquence de comptage peut être introduite dans le compteur (10), dispositif caractérisé en ce qu'une structure de circuit logique (18) est prévue, par l'intermédiaire de laquelle une fréquence de comptage, parmi plusieurs fixées à l'avance, peut être introduite dans le compteur (10) par la porte (12) et en ce que la structure de circuit logique est reliée aux sorties des étages (8, 9) de comptage du compteur, en vue du branchement de chacune des fréquences de comptage affectées à un niveau ou à une indication du compteur.

4. Dispositif comportant un compteur à plusieurs étages selon la revendication 3, caractérisé en ce que seuls les deux étages (8, 9) les plus élevés du compteur sont reliés à la structure de circuit logique (18).

FIG.1

FIG. 2

1